# EUROPÄISCHE PATENTSCHRIFT

(11) **EP 4 063 813 B1**
(45) Veröffentlichungstag und Bekanntmachung des Hinweises auf die Patenterteilung: **20.11.2024**
(21) Anmeldenummer: 22163733.3
(22) Anmeldetag: 23.03.2022
(51) Int. Cl.: G01K 1/143, G01K 7/02, G01K 13/02

(54) **TEMPERATURSENSOR**
TEMPERATURE SENSOR
CAPTEUR DE TEMPÉRATURE

(30) Priorität: 25.03.2021 DE 102021107608
(43) Veröffentlichungstag der Anmeldung: 28.09.2022
(73) Patentinhaber: WIKA Alexander Wiegand SE & Co. KG, 63911 Klingenberg (DE)
(72) Erfinder: STAAB, Ulrich, 63911 Klingenberg (DE)
(74) Vertreter: Liedtke & Partner Patentanwälte

(56) Entgegenhaltungen:
- US-A- 4 043 200
- US-A- 4 164 433

## Beschreibung

### TECHNISCHES GEBIET

Die Erfindung bezieht sich auf einen Temperatursensor mit einem Thermoelement, insbesondere für eine Hochtemperaturmessung.

Entsprechende Temperatursensoren sind aus dem Stand der Technik allgemein bekannt.

Beispielsweise ist aus der US 5 141 335 A ein Thermoelement-Temperaturfühler für Temperaturmessungen an Oberflächen bekannt. Die Thermoelement-Leitungen, auch als Thermodrähte bezeichnet, sind hierin mit einem Isolationsmaterial in einer Mantelleitung an ein Gehäuseteil herangeführt. Die Mantelleitung ist in eine Öffnung des Gehäuses eingeführt und dichtend mit diesem verschweißt. Die Thermodrähte werden innerhalb des Gehäuseteils an einen Messpunkt am Gehäuseboden geführt und dort miteinander und mit dem Gehäuseboden verschweißt. Sie bilden dadurch ein Thermoelement, welches direkt im Gehäuseboden angeordnet ist. Der Temperaturfühler wird anschließend mit dem Gehäuseboden auf eine Oberfläche, deren Temperatur gemessen werden soll, gesetzt und auf dieser angeschweißt. Das Thermoelement im Gehäuseboden steht somit praktisch in direktem Kontakt mit der Oberfläche. Dadurch verfügt es über eine hohe Messgenauigkeit und schnelle Antwortzeit.

Typische Anwendungen für derartige Temperatursensoren sind Temperaturmessungen an Rohrleitungen oder Anlagengefäßen, die Teil einer industriellen Anlage sind. Solche Anlagen finden sich beispielsweise in der chemischen und petrochemischen Industrie. Häufig sind solche Rohrleitungen oder Anlagengefäße dann auch innerhalb einer Prozesskammer angeordnet, beispielsweise einem Hochofen oder einem Reaktor. Die Temperatursensoren können dann also insbesondere einer aggressiven, abrasiven und/oder sehr heißen Atmosphäre ausgesetzt sein. Solche Atmosphären werden im Weiteren allgemein als Prozessatmosphären bezeichnet und zusammengefasst. Rohre, Anlagengefäße und sämtliche andere Strukturen, die Teil einer industriellen Anlage sind und deren Oberfläche Gegenstand von Temperaturmessungen mit gattungsgemäßen Temperatursensoren sind, werden weiterhin im Folgenden allgemein als Prozessstrukturen bezeichnet und zusammengefasst. Die Mantelleitung und das Gehäuse erfüllen in solchen Anwendungen, neben der Führung und Positionierung des Thermoelements und der Thermodrähte zu oder an einer gewünschten Messstelle, eine Schutzfunktion: Sie schirmen die Prozessatmosphäre in einem gewissen Maße und/oder für eine gewisse Zeit von den Thermodrähten und dem Thermoelement ab.

Weiterhin werden im Stand der Technik bekannte Temperatursensoren auch dazu verwendet, eine Temperatur eines Prozessfluids innerhalb einer Prozesskammer oder innerhalb eines Rohres - allgemein innerhalb einer Prozessstruktur - zu messen. Für diese Anwendungen werden im Allgemeinen sogenannte Schutzrohre verwendet, welche hinreichend im Stand der Technik beschrieben sind, beispielsweise in der WO 2020/035402 A1. Wenn im Weiteren von einer Anordnung eines Temperatursensors innerhalb eines Prozessfluids gesprochen wird, sind damit ebenso Anordnungen gemeint, bei denen der Temperatursensor oder ein Schutzrohr, welches den Temperatursensor aufnimmt, in ein Prozessfluid eintaucht oder bei denen ein Temperatursensor mit einem Prozessfluid in Berührung kommt. Dem Schutzrohr oder einem ähnlichen Aufbau kommt in dieser Anwendung neben der Führung und Positionierung des Thermoelements und der Thermodrähte zu oder an eine gewünschte Messstelle innerhalb des Prozessfluids oder angrenzend an das Prozessfluid auch eine Schutzfunktion zu: Es schirmt das Prozessfluid in einem gewissen Maße und/oder für eine gewisse Zeit von den Thermodrähten und dem Thermoelement ab, lässt aber gleichzeitig einen thermischen Kontakt zu.

Das Prozessfluid kann dabei in einer Flüssigphase, einer Gasphase, als Festkörper, zum Beispiel als Staub oder Granulat, oder auch in einer Mischform vorliegen. Gleiches gilt für die im Vorangehenden erwähnten Prozessatmosphären. Diese beiden verschiedenen Begriffe werden im Folgenden lediglich verwendet, um die unterschiedlichen Anwendungen klar voneinander getrennt zu benennen: Der Begriff Prozessatmosphäre meint ein in der Umgebung eines Temperatursensors vorliegendes Fluid, gegenüber dessen Einwirken, welches beispielsweise chemisch, mechanisch, o. ä. ist, der Temperatursensor gegebenenfalls durch ein Gehäuse oder eine Mantelleitung geschützt wird, während der Temperatursensor nicht die Temperatur dieser Prozessatmosphäre, sondern die Temperatur einer Oberfläche einer Prozessstruktur innerhalb dieser Prozessatmosphäre messen soll. Der Begriff Prozessfluid meint hingegen ein Fluid in der Umgebung eines Temperatursensors, gegenüber dessen Einwirken der Temperatursensor zwar durch ein Schutzrohr oder einen ähnlichen Aufbau geschützt wird, während der Temperatursensor aber dem Zweck dient, gerade die Temperatur dieses Fluids möglichst genau zu messen.

Entsprechenden Temperatursensoren aus den vorangehend beschriebenen Anwendungen aus dem Stand der Technik ist gemein, dass diese in Hochtemperatur-Anwendungen durch Einflüsse durch die raue Umgebung, insbesondere durch die chemischen oder mechanischen Eigenschaften der Prozessatmosphäre oder des Prozessfluids und/oder durch die hohe Temperatur der Oberfläche der Prozessstrukturen oder der Prozessatmosphäre oder des Prozessfluids, langfristig beeinträchtigt werden. Hierbei ist zu beobachten, dass die Messwerte zunehmend von einer tatsächlichen Temperatur der Oberfläche, der Atmosphäre oder des Fluids abweichen. Dies wird im Allgemeinen als Messwertdrift bezeichnet. Das heißt, der Messwert driftet vom tatsächlichen Wert weg. Folglich müssen die Temperatursensoren regelmäßig überprüft und gegebenenfalls ausgetauscht werden. Beides ist äußerst kostenintensiv, da eine Prozessanlage dafür in der Regel zunächst heruntergefahren, das heißt abgeschaltet werden muss.

Um eine Überprüfung der Temperatursensoren im laufenden Betrieb möglich zu machen, sind in verschiedenen Schriften Techniken und Anordnungen beschrieben, mit denen eine sogenannte In-Situ Kalibrierung eines Temperatursensors durchgeführt werden kann. So beschreibt die DE 10 2017 100 268 A1 etwa eine Anordnung eines Thermoelement-Temperatursensors innerhalb eines Schutzrohres zusammen mit einem Referenzelement, welches durch einen physikalischen Phasenübergang bei einer bestimmten Temperatur ein Referenzsignal erzeugt und somit eine Ein-Punkt-Kalibrierung ermöglicht. Diese und ähnliche Anordnungen erlauben in einigen Anwendungen eine ungefähre Korrektur eines Messwertdrifts. Jedoch zeigt sich, dass insbesondere Thermoelemente für Oberflächentemperaturmessungen im Hochtemperatur-Messbereich durch diese Methode nicht hinreichend korrigiert werden können. Ein Grund dafür liegt gegebenenfalls darin, dass mögliche Referenzpunkte, welche durch diese Systeme erzeugt werden, in der Regel bei niedrigeren Temperaturen liegen, die im laufenden Betrieb der Prozessanlage gar nicht erreicht werden. Somit liegen die Referenzpunkte weit abseits eines eigentlichen Arbeitsbereichs, sodass die Kalibrierung nicht optimal ist. Abgesehen davon können in diesen Anwendungen auch Beeinträchtigungen der Thermoelemente oder ThermoDrähte vorliegen, welche aus methodischen Gründen durch diese In-Situ Kalibrierung nicht korrigiert werden können.

Die US 4 164 433 A beschreibt röhrenförmige Thermoelementanordnung mit einem ein ummanteltes Thermoelementkabel mit einem winklig angeordneten Fühlerende, das in einer Endfläche endet, die sich parallel zu einer Achse eines benachbarten axialen Abschnitts einer Ummantelung erstreckt. Eine Messverbindung von Leitern ist in einem Endhohlraum in einem Sensorende frei von Isoliermaterial ausgebildet und mit Füllmetall gefüllt, das die Messverbindung darin einbettet, wobei das Füllmetall einen Endverschluss mit einer freiliegenden Fläche bereitstellt, die bündig mit der Endfläche ist und eine Kontaktfläche bildet, die für einen durchgehenden engen Kontakt mit einer Rohroberfläche ausgebildet ist.

Weiterhin beschreibt die US 4 043 200 A Oberflächenthermoelementanordnung mit einer Metallhülle mit Thermoelementleitern, die sich in einem Abstand voneinander und von der Hülle durch elektrisch isolierendes Material hindurcherstrecken, einer Öffnung in der Hüllenwand an einem Verbindungsende, durch welche die Thermoelementleiter verlaufen. In der Öffnung ist ein Keramikstopfen angeordnet, welcher die Thermoelementleiter aufnimmt. Außerhalb des Keramikstopfens sind die Thermoelementleiter miteinander verschweißt. Es ist ein V-förmiges Pad mit einer messerförmigen Kante vorgesehen, welche integral am Verbindungsende ausgebildet ist.

### AUFGABE DER ERFINDUNG

Es ist daher die Aufgabe der Erfindung, einen neuartigen Temperatursensor mit einem Thermoelement bereitzustellen.

Die Aufgabe wird gelöst durch einen Temperatursensor, welcher die im Anspruch 1 angegebenen Merkmale aufweist.

Mögliche Weiterbildungen und Weiterentwicklungen des Temperatursensors sind Gegenstand der abhängigen Ansprüche.

### ZUSAMMENFASSUNG DER ERFINDUNG

Der Temperatursensor umfasst einen ersten Leiter aus einem ersten Material mit einem Endabschnitt, einen zweiten Leiter aus einem zweiten Material, welches sich vom ersten Material unterscheidet, mit einem Endabschnitt, sowie ein Gehäuse zur Aufnahme der Endabschnitte der beiden Leiter. Das Gehäuse ist zu einer Positionierung in einer Prozessatmosphäre oder in einem Prozessfluid und/oder an einer Oberfläche einer Prozessstruktur ausgebildet. Erfindungsgemäß umfasst der Temperatursensor einen Messstellenkörperaufbau, welcher innerhalb des Gehäuses oder an dem Gehäuse angeordnet ist. Dabei bilden der erste Leiter und der zweite Leiter in dem oder an dem Messstellenkörperaufbau unmittelbar oder mittelbar ein Thermoelement und der Messstellenkörperaufbau umfasst ein Barriere-Material.

Der vorliegende Temperatursensor ist in besonders vorteilhafter Weise weniger anfällig für Beeinträchtigungen durch Umgebungseinflüsse oder schließt diese sogar aus. Gleichzeitig weist er eine geringe Antwortzeit und hohe Messgenauigkeit auf.

Der erste Leiter und der zweite Leiter, zusammengenommen im Weiteren auch die beiden Leiter, sind beispielsweise als Drähte oder Thermoelementdrähte ausgebildet. Als Endabschnitte werden insbesondere jene Endbereiche oder Enden der beiden Leiter bezeichnet, die miteinander mittelbar oder unmittelbar ein Thermoelement ausbilden und zur Temperaturmessung in einer Prozessatmosphäre oder einem Prozessfluid und/oder auf der Oberfläche einer Prozessstruktur vorgesehen sind. Dazu sind diese insbesondere an eine Messstelle an dem Gehäuse oder innerhalb des Gehäuses herangeführt. Zum Schutz vor Umgebungseinflüssen können die Leiter auf einer Strecke außerhalb des Gehäuses bis zu einer vorgesehenen Referenzstelle, an welcher die Leiter mit einer Auswerteeinheit in elektrische Verbindung gebracht werden, durch eine mineralisolierte Leitung, auch als MI-Leitung oder nur Mantelleitung bezeichnet, geführt sein. Eine solche Mantelleitung weist in der Regel einen metallischen Mantel, insbesondere einen Stahlmantel, auf.

Ein Gehäuse im Sinne dieser Erfindung weist insbesondere die Eigenschaft auf, die Endbereiche der beiden Leitungen aufzunehmen. Dies bedeutet im Kontext der Erfindung, dass die beiden Leiter an das Gehäuse herangeführt sind und zumindest abschnittsweise in das Gehäuse, also in einen Gehäuseinnenraum oder ein freies Innenvolumen des Gehäuses, eindringen und dabei in Ihren jeweiligen Endabschnitt übergehen, um dann an einer vorgesehenen Messstelle oder einem vorgesehenen Kontaktpunkt mittelbar oder unmittelbar ein Thermoelement zu bilden. Das Gehäuse erfüllt dadurch die Funktion, die Endbereiche der beiden Leiter vor Umgebungseinflüssen zu schützen sowie das gebildete Thermoelement an einer vorgesehenen Messstelle zu positionieren, insbesondere auch an einer solchen Stelle zu befestigen. Das Gehäuse kann entsprechend bekannter Gehäuse aus dem Stand der Technik ausgeformt sein und kann insbesondere an einem offenen Ende der Mantelleitung angeordnet sein oder mit dieser verbunden sein, zum Beispiel durch eine Schweißverbindung. Das heißt, die MI-Leitung geht direkt in das Gehäuse über, wo die Endabschnitte der Leiter dann ein Thermoelement ausbilden. Dadurch können die beiden Leiter in gewissem Maße und/oder für eine gewisse Zeit vor beeinträchtigenden Umgebungseinflüssen geschützt werden. Auch kann das Gehäuse durch einen Abschnitt, insbesondere durch ein verschlossenes Ende der MI-Leitung oder Mantelleitung selbst, gebildet sein. In einer möglichen Ausgestaltung kann das Gehäuse oder ein freies Innenvolumen des Gehäuses mit einem elektrischen Isolationsmaterial aufgefüllt sein. Das Isolationsmaterial kann ein mineralisches oder keramisches Pulver sein, wie es zum Beispiel auch zum Ausfüllen einer Mantelleitung verwendet wird. Dadurch kann eine gute Isolation der Leiter abseits des Messstellkörperaufbaus erreicht werden.

Der erste und der zweite Leiter bilden in oder an dem Messstellenkörperaufbau mittelbar oder unmittelbar ein Thermoelement. Der Messstellenkörperaufbau, insbesondere der Teil des Aufbaus, welcher aus dem Barriere-Material gebildet ist, schützt dabei das Thermoelement, das heißt die Messstelle, effektiv vor Beeinträchtigungen durch bestimmte Umgebungseinflüsse, wodurch eine langfristige Funktion und Messwertgenauigkeit des Temperatursensors ermöglicht werden.

Der Messstellenkörperaufbau im Sinne dieser Erfindung oder einer Weiterbildung kann ein einteiliger oder mehrteiliger Aufbau sein. Er kann eines oder mehrere Teile umfassen, welche aus dem Barriere-Material geformt sind, oder kann komplett aus dem Barriere-Material gebildet sein. Bei einem mehrteiligen Messstellenkörperaufbau können alle oder einige der Teile direkt aneinander angeordnet oder miteinander verbunden sein oder aber voneinander beabstandet, insbesondere getrennt im oder am Gehäuse angeordnet, sein. Durch die Vielfalt dieser Ausgestaltungsmöglichkeiten des Messstellenkörperaufbaus kann dieser an verschiedene Einbausituationen angepasst werden. Insbesondere können Ausführungsformen gewählt werden, die besonders kostengünstig herzustellen oder besonders robust sind. Konkrete Vorteile einzelner Ausführungen und Weiterbildungen sind Gegenstand noch folgender Beschreibungsteile.

Eine Anordnung des Messstellenkörperaufbaus innerhalb des Gehäuses bedeutet im Sinne dieser Erfindung insbesondere, dass der Messstellenkörperaufbau keinen direkten Kontakt mit der Prozessatmosphäre oder dem Prozessfluid, welche oder welches das Gehäuse gegebenenfalls umgibt, und/oder mit der Oberfläche der Prozessstruktur, an welcher das Gehäuse gegebenenfalls angeordnet ist, aufweist. Es liegt also noch ein Materialabschnitt des Gehäuses zwischen dem Messstellenkörperaufbau und der Umgebung. Dieser Abschnitt kann insbesondere durch eine Gehäusewand gebildet sein, wobei der Messstellenkörperaufbau dabei beispielsweise in einer Ausnehmung oder Vertiefung an der Innenseite der Gehäusewand angeordnet sein kann. Der Messstellenkörperaufbau kann jedoch auch derart innerhalb eines freien Innenvolumens des Gehäuses angeordnet sein, dass er nicht mit dem Gehäuse selbst in Berührung kommt. Durch diese Aufbauvarianten kann in vorteilhafter Weise das gegebenenfalls sehr hochwertige Barriere-Material, welches besonders effektiv gegen bestimmte Umgebungseinflüsse und Effekte wirkt, mit dem Schutz durch das gegebenenfalls weniger hochwertige Gehäusematerial vor mechanischen Einwirkungen, wie Einschlägen oder Abrieb, kombiniert werden.

Eine Anordnung des Messstellenkörperaufbaus an dem Gehäuse bedeutet im Sinne dieser Erfindung insbesondere, dass der Messstellenkörperaufbau nicht vollständig durch das Gehäuse von der umgebenden Prozessatmosphäre oder dem Prozessfluid oder der anliegenden Oberfläche der Prozessstruktur abgetrennt ist, also nicht vollständig vom Gehäuse umschlossen wird. Beispielsweise kann der Messstellenkörperaufbau derart in einer Gehäusewand angeordnet sein, dass er diese durchstößt und abschnittsweise direkt mit dem Prozessfluid oder der Oberfläche der Prozessstruktur in Kontakt tritt, deren Temperatur gemessen werden soll. In einer solchen Ausführung ist der Messstellenkörperaufbau zwar nicht mehr wie in der vorangehend genannten Ausführungsvariante durch eine Gehäusewand besonders vor mechanischen Angriffen geschützt, jedoch können in dieser Variante vorteilhaft eine noch schnellere Antwortzeit des Temperatursensors sowie ein genauerer Messwert erzielt werden, da der Messstellenkörperaufbau direkt der zu messenden Temperaturquelle ausgesetzt ist.

Eine unmittelbare Ausbildung eines Thermoelements meint im Sinne dieser Erfindung insbesondere, dass der erste Leiter und der zweite Leiter sich direkt berühren und elektrisch verbunden sind, also das Material des ersten Leiters einen direkten, unmittelbaren Kontaktpunkt mit dem Material des zweiten Leiters ausbildet. Dieser Kontaktpunkt bildet dann das Thermoelement, also die Messstelle des Sensors.

Der Erfindung liegt die Erkenntnis zu Grunde, dass die größte Ursache von Beeinträchtigungen von gattungsgemäßen Temperatursensoren in einer Diffusion von Partikeln, Molekülen oder Teilchen aus der Prozessatmosphäre, dem Prozessfluid, der Oberfläche der Prozessstruktur oder aus dem Material des Gehäuses hinein in das Thermoelement oder hinein in einen oder beide Leiter, die das Thermoelement bilden, besteht. Dieser Prozess läuft nur sehr langsam ab, oftmals auf einer Zeitskale von Monaten oder Jahren. Eine häufige Folge dieser Diffusion ist, dass die tatsächliche Messstelle, also der Ort, an welchem die Thermospannung entsteht, nicht mehr genau an dem Kontaktpunkt der beiden Thermodrähte oder auch Leiter liegt, sondern von diesem Kontaktpunkt entlang der Leiter "wegläuft". Dies wird im Weiteren als Messstellenwanderung bezeichnet. Abhängig von den konkreten Gegebenheiten der individuellen Anwendung liegt die Messstelle dann an einer Position, die eine höhere oder niedrigere Temperatur aufweist, als sie am eigentlichen Kontaktpunkt vorliegt. Somit driftet das Messsignal schleichend vom tatsächlich relevanten Wert weg. Das Eintreten dieses Effekts lässt sich jedoch ohne eine Entfernung und aufwändige Materialanalyse des Temperatursensors nicht feststellen. Ein Betreiber der Prozessanlage wird seine Prozesse folglich auf zunehmend stärker von der tatsächlichen Prozesstemperatur abweichende Temperaturmesswerte steuern, wodurch in vielen Anwendungen enorme Effizienzeinbrüche oder sogar gefährliche Zustände entstehen können.

Deshalb wird diesem Effekt effektiv entgegengetreten und somit die Schutzfunktion des Messstellenkörperaufbaus besonders effektiv umgesetzt. Dies erfolgt dadurch, dass das Barriere-Material derart gewählt wird, dass dieses bei gleicher Temperatur einen niedrigeren Diffusionskoeffizienten für mindestens eine in der Prozessatmosphäre oder in dem Prozessfluid oder im Material der Oberfläche der Prozessstruktur oder im Material des Gehäuses vorhandene Komponente aufweist, als die Materialien der beiden Leiter selbst. Somit kann eine Diffusion dieser Komponenten, also von Partikeln, Molekülen oder Teilchen, in das Thermoelement hinein effektiv aufgehalten oder zumindest drastisch verzögert werden, was eine deutlich höhere Langzeit-Messgenauigkeit des Temperatursensors ermöglicht und eine Messstellenwanderung aufhält oder zumindest stark bremst. Diese Komponente aus der Prozessatmosphäre oder dem Prozessfluid oder der Oberfläche der Prozessstruktur oder dem Material des Gehäuses wird im Folgenden auch als Fremdkomponente bezeichnet. Diese Bezeichnung soll jedoch nicht darauf hindeuten, dass die Fremdkomponente kein Bestandteil des ersten Materials oder des zweiten Materials sein kann. Der Begriff soll lediglich unterstreichen, dass ein konkreter Partikel, ein Teilchen oder Molekül dieser Fremdkomponente eben aus der Prozessatmosphäre, dem Prozessfluid, der Oberfläche der Prozessstruktur oder dem Material des Gehäuses - quasi von außerhalb der Leiter - in einen der Leiter, insbesondere einen Endabschnitt, hineindiffundieren würde, wenn dies nicht durch das Barriere-Material verhindert oder verzögert wird.

Diese Fremdkomponente oder Fremdkomponenten können insbesondere einer oder mehrere der folgenden Stoffe sein: Kohlenstoff, Schwefel, Chrom, Nickel, Eisen, Kupfer oder eine Verbindung eines dieser Stoffe. Darüber hinaus und generell kann die Schutzwirkung des Messstellenkörperaufbaus besonders effektiv umgesetzt werden, wenn dieser einen besonders geringen Diffusionskoeffizienten für eine oder mehrere der Fremdkomponenten aufweist, welche jedoch auch im ersten Material des ersten Leiters und/oder zweiten Material des zweiten Leiters selbst vorkommen.

In möglichen Weiterbildungen der Erfindung kann ein unmittelbarer Kontaktpunkt auf oder an einer Oberfläche des Messstellenkörperaufbaus anliegend gebildet sein. In diesem Fall ist der Messstellenkörperaufbau oder der Teil des Messstellenkörperaufbaus, welcher aus dem Barriere-Material geformt ist, so angeordnet, dass er zwischen dem Thermoelement und jenem dem Thermoelement am nächsten kommenden Teil der Prozessatmosphäre oder der Oberfläche der Prozessstruktur angeordnet ist. Somit kann das Thermoelement effektiv und unter Verwendung von einer geringen Menge an Barriere-Material schon gegen eine große Quelle von negativen Beeinflussungen durch die Umgebung geschützt werden. Das Barriere-Material kann hierbei insbesondere als Plättchen oder Scheibe ausgebildet sein, die beispielsweise in eine Vertiefung an der Innenseite einer Gehäusewand eingesetzt ist. Ist der Kontaktpunkt im Messstellenkörperaufbau angeordnet, kann vorgesehen sein, dass der Messstellenkörperaufbau oder der Teil oder die Teile des Messstellenkörperaufbaus, welcher oder welche aus dem Barriere-Material gebildet ist oder sind, so angeordnet ist oder sind, dass das Thermoelement aus mehreren räumlichen Richtungen vor Umgebungseinflüssen geschützt ist. Insbesondere kann der Kontaktpunkt komplett von Barriere-Material umgeben oder in dieses eingebettet sein, wodurch eine Schutzfunktion vor Beeinträchtigungen durch Umgebungseinflüsse noch gesteigert wird.

Eine mittelbare Ausbildung eines Thermoelements meint im Sinne dieser Erfindung insbesondere, dass der erste Leiter und der zweite Leiter sich nicht direkt berühren. Das heißt, das Material des ersten Leiters bildet keinen direkten, unmittelbaren Kontaktpunkt mit dem Material des zweiten Leiters aus. Stattdessen sind die beiden Leiter in diesem Fall durch einen oder mehrere andere Materialabschnitte leitend miteinander verbunden. Diese anderen Materialabschnitte können Materialabschnitte des Messstellenkörperaufbaus, insbesondere Materialabschnitte aus dem Barriere-Material, und/oder des Gehäuses sein. Was im Sinne dieser Erfindung als unmittelbar gebildetes Thermoelement bezeichnet wird, setzt sich folglich insbesondere aus einer Reihe von mindestens zwei ungleichen Thermoelementen zusammen. Der Messstellenkörperaufbau ist dabei insbesondere derart ausgebildet, dass diese einzelnen ungleichen Thermoelemente nahe beieinander angeordnet sind, sodass diese sich im Wesentlichen auf dem gleichen Temperaturniveau befinden.

In möglichen Weiterbildungen der Erfindung kann der Messstellenkörperaufbau dabei einen einzelnen Messstellenkörper aufweisen, der den Endbereich des ersten Leiters und/oder den Endbereich des zweiten Leiters aufnimmt oder zumindest mit beiden Leitern in direktem Kontakt steht. Unter einer Aufnahme eines Leiters wird hierbei insbesondere verstanden, dass der Endbereich des Leiters in den Messstellenkörper eingeführt ist und von diesem gehalten wird. Der Messstellenkörper kann dazu beispielsweise in einer Hülsenform mit zwei voneinander getrennten, parallelen Kanälen oder als Topf mit zwei voneinander getrennten Bohrungen ausgebildet sein. Zwischen zwei Kanälen oder Bohrungen kann eine Trennwand angeordnet sein, welche beispielsweise eine Stärke von mindestens 0,1 mm aufweist. Die Wandstärke der Hülse oder die Stärke einer Außenwand, welche die Bohrungen umgibt, kann ebenfalls mindestens 0,1 mm betragen. Auch kann der Messstellenkörper mehrteilig ausgeführt sein. Der Messstellenkörper kann so zum Beispiel aus zwei sich berührenden Teilkörpern, die jeweils nur den Endbereich von einem der beiden Leiter aufnehmen, oder durch zwei Halbschalen, welche die Endbereiche der beiden Leiter zwischen einander einschließen, ohne dass die Endbereiche sich dabei direkt berühren, gebildet sein. Weiterhin kann der Messstellenkörper auch nur den Endbereich von einem der beiden Leiter aufnehmen, während der Endbereich des anderen Leiters mit einer Oberfläche des Messstellenkörpers in direktem Kontakt steht, aber nicht vom Messstellenkörper aufgenommen wird. Ein solcher direkter Kontakt zwischen Messstellenkörper und einem Leiter kann schon dadurch zustande kommen, dass der Leiter an die Oberfläche des Messstellenkörpers herangeführt ist, diese berührt oder mit dieser verbunden ist, insbesondere stoffschlüssig verbunden ist. Auch kann der Messstellenkörper mit beiden Leitern in dieser Weise in direktem Kontakt stehen und keinen der Endbereiche in sich aufnehmen. Dazu kann der Messstellenkörper insbesondere als Plättchen oder Scheibe ausgebildet sein und so angeordnet sein, dass er zwischen dem Thermoelement und jenem dem Thermoelement am nächsten kommenden Teil der Prozessatmosphäre, des Prozessfluids oder der Oberfläche der Prozessstruktur angeordnet ist. Somit kann das Thermoelement effektiv und unter Verwendung von einer geringen Menge an Barriere-Material, also durch einen relativ kleinen Messstellenkörper, schon gegen eine große Quelle von negativen Beeinflussungen durch die Umgebung geschützt werden.

In einer möglichen Weiterbildung dieser Ausgestaltung besteht der Messstellenkörper dabei selbst aus dem Barriere-Material. Dadurch kann der Messstellenkörperaufbau besonders simpel aufgebaut sein, kann insbesondere gerade nur aus dem einzelnen Messstellenkörper bestehen. Somit wird insbesondere eine einfache und kostengünstige Herstellung ermöglicht. Das mittelbar gebildete Thermoelement umfasst in dieser Ausgestaltung dann insbesondere ein erstes Thermoelement, gebildet durch den Kontakt zwischen dem Material des ersten Leiters und dem Barriere-Material, sowie ein zweites Thermoelement, gebildet durch den Kontakt zwischen dem Barriere-Material und dem Material des zweiten Leiters. Die beiden unterschiedlichen Thermoelemente können in dieser Ausgestaltung besonders nahe beieinander angeordnet werden, sodass diese im Wesentlichen die gleiche Temperatur annehmen. Dies minimiert das Risiko der Beeinträchtigung der Messgenauigkeit durch unterschiedliche Temperaturen der beiden Messstellen.

In einer weiteren möglichen Weiterbildung der Erfindung, in welcher ebenfalls ein Thermoelement mittelbar ausgebildet wird, sind die Endbereiche der beiden Leiter über mindestens einen Abschnitt des Messstellenkörperaufbaus, insbesondere über einen Abschnitt des Barriere-Materials des Messstellenkörperaufbaus, und mindestens einen Abschnitt des Gehäuses elektrisch miteinander verbunden. Dadurch erhöht sich zwar grundsätzlich eine Anzahl der einzelnen verschiedenen Thermoelemente, welche zu der mittelbaren Ausbildung des Thermoelements beitragen, diese können jedoch nahe beieinander angeordnet werden, sodass diese im Wesentlichen die gleiche Temperatur einnehmen können und somit keine Nachteile entstehen. Dafür kann ein solcher Aufbau zu einer erweiterten Modularisierung des Aufbaus des Temperatursensors, insbesondere zu einer Vereinfachung des Messstellenkörperaufbaus und dessen Bauteile, beitragen.

So kann der Messstellenkörperaufbau in einer Weiterentwicklung dieser Weiterbildung beispielsweise zwei separate, getrennte Messstellenkörper aufweisen. Dabei nimmt jeder dieser Messstellenkörper jeweils den Endbereich von einem der beiden Leiter auf oder steht jeweils mit diesem in unmittelbarem Kontakt. Die beiden Messstellenkörper bestehen hierbei insbesondere aus dem Barriere-Material. Diese getrennten Messstellenkörper können dazu insbesondere als Hülsen ausgebildet sein, die jeweils den Endbereich von einem der beiden Leiter aufnehmen. Ebenso können die Messstellenkörper eine Topfform aufweisen oder als Plättchen oder Scheibe ausgebildet sein, wobei in den letzten beiden Fällen jeder der beiden Messstellenkörper mit einem Endbereich von einem der beiden Leiter in direktem Kontakt steht. Die beiden Messstellenkörper sind beabstandet voneinander angeordnet, berühren sich also nicht direkt. In einer möglichen Ausführungsform sind sie beispielsweise in Vertiefungen, Ausnehmungen oder Durchbrüchen in einer Gehäusewand angeordnet. Über das Material der Gehäusewand sind die beiden getrennten Messstellenkörper elektrisch miteinander verbunden. Durch diese Weiterbildung ist ein besonders einfacher und kostengünstiger Aufbau möglich. Beispielsweise lassen sich auf diese Weise besonders kompakte und einfach geformte Messstellenkörper verwenden, die in hoher Stückzahl gefertigt werden können und somit sehr günstig sind.

Sind die beiden getrennten Messstellenkörper, im Weiteren auch als erster und zweiter Messstellenkörper bezeichnet, selbst direkt aus dem Barriere-Material gebildet, verringert sich weiter die Anzahl der Bauteile und der Montageaufwand. Das mittelbar gebildete Thermoelement umfasst in dieser Ausgestaltung dann ein erstes Thermoelement, gebildet durch den Kontakt zwischen dem Material des ersten Leiters und dem Barriere-Material des ersten Messstellenkörpers, ein zweites Thermoelement, gebildet durch den Kontakt zwischen dem Barriere-Material des ersten Messstellenkörpers und dem Material der Gehäusewand, ein drittes Thermoelement, gebildet durch den Kontakt zwischen dem Material der Gehäusewand und dem Barriere-Material des zweiten Messstellenkörpers, sowie ein viertes Thermoelement, gebildet durch den Kontakt zwischen dem Barriere-Material des zweiten Messstellenkörpers und dem Material des zweiten Leiters. Die vier unterschiedlichen Thermoelemente können in dieser Ausgestaltung besonders nahe beieinander angeordnet werden, sodass diese im Wesentlichen die gleiche Temperatur annehmen. Dies minimiert das Risiko der Beeinträchtigung der Messgenauigkeit durch unterschiedliche Temperaturen der vier Messstellen.

Sowohl die vorangehend genannten Weiterbildungen der Erfindung, die einen einzelnen Messstellenkörper aufweisen, als auch jene, welche zwei getrennte Messstellenkörper aufweisen, können durch die im Folgenden beschriebenen Weiterbildungen in Bezug auf die Ausgestaltung des Messstellenkörpers oder der getrennten Messstellenkörper noch weiter verbessert werden.

In einer möglichen Weiterbildung ist der oder sind die Messstellenkörper jeweils einteilig und/oder einstückig ausgeformt und bestehen aus dem Barriere-Material. Dadurch kann der Temperatursensor besonders einfach und kostengünstig hergestellt werden, da sich eine Teilezahl verringert.

In einer weiteren möglichen Weiterbildung ist der oder sind die Messstellenkörper mehrteilig ausgebildet, wobei insbesondere aber alle Teile aus dem Barriere-Material bestehen. In dieser Ausführung erhöht sich zwar die Anzahl der Bauteile, jedoch können in dieser Weise besonders günstige Montageschritte ermöglicht werden. Beispielsweise können der oder die Messstellenköper jeweils aus zwei Halbschalen oder Platten bestehen, zwischen welchen ein oder beide Leiter geklemmt werden kann oder können. Somit ist es dann nicht nötig, Leiter an den Messstellenkörpern anzulöten oder anzuschweißen. Außerdem können Fertigungstoleranzen der Messstellenkörper großzügiger gewählt werden.

In einer weiteren möglichen Weiterbildung ist der oder sind die Messstellenkörper durch eine Beschichtung oder eine Lackierung des Endbereichs von wenigstens einem der Leiter mit dem Barriere-Material oder durch Einhüllung des Endbereichs von wenigstens einem der Leiter in eine Folie aus dem Barriere-Material gebildet. Der oder die Messstellenkörper müssen also nicht zwingend durch einen Formkörper mit Maßen in der gleichen Größenordnung, wie etwa die Drahtstärke der beiden Leiter, gebildet sein, sondern können auch durch dünne, gegebenenfalls mikroskopisch dünne Schichten geformt sein. Eine Beschichtung der Endabschnitte kann dabei insbesondere durch ein Eintauchen der Endabschnitte in eine Schmelze des Barriere-Materials erfolgen.

Beispielsweise muss dabei die Stärke der Beschichtung aus dem Barriere-Material nur mindestens so stark sein, dass mögliche Unebenheiten der Oberfläche der beiden Thermoelement-Leiter ausgeglichen werden, also die Barriere-Material-Schicht nicht durch solche Unebenheiten oder Rauigkeiten durchbrochen wird. Diese Ausführungsform hat den Vorteil, dass nur äußerst geringe Mengen des Barriere-Materials benötigt werden. Außerdem reduziert sich weiterhin die Anzahl der Bauteile, wodurch sich eine noch kostengünstigere Fertigung erzielen lässt und der Aufbau besonders kompakt gestaltet werden kann.

Dabei kann die Beschichtung des Endbereichs oder der Endbereiche auch aus einer Reihe von zwei oder mehreren Schichten aus verschiedenen Barriere-Materialien bestehen. Dadurch kann der Messstellenkörperaufbau einer besonders großen Vielzahl von Umgebungseinflüssen entgegenwirken.

In einer weiteren möglichen Weiterbildung weist der oder weisen die Messstellenkörper eine Topfform oder eine Plattenform oder eine Hülsenform auf. Diese Formen sind einfach und kostengünstig herzustellen, sind jedoch gleichzeitig sehr gut dafür geeignet, mit dem Thermoelement in direkten Kontakt gebracht zu werden oder einen oder mehrere Leiter aufzunehmen.

In einer weiteren möglichen Weiterbildung ist der oder sind die Messstellenkörper durch eine Presspassung im oder am Gehäuse angeordnet. Wie bereits in den vorangehenden Ausführungen beschrieben, bedeutet eine Anordnung im Gehäuse insbesondere, dass der oder die Messstellenkörper nicht in direkten Kontakt mit der Prozessatmosphäre, dem Prozessfluid oder der Oberfläche der Prozessstruktur kommt oder kommen, sondern durch eine - wenn auch insbesondere sehr dünne - Gehäusewand davon abgetrennt ist oder sind. Eine Anordnung am Gehäuse bedeutet auch im Kontext dieser Weiterbildung insbesondere, dass der oder die Messstellenkörper in direkten Kontakt mit dem Prozessfluid oder der Oberfläche der Prozessstruktur kommt oder kommen, dessen oder deren Temperatur gemessen werden soll, also beispielsweise eine Gehäusewand durchdringt oder durchdringen.

Durch die Nutzung einer Presspassung kann der oder können die Messstellenkörper zuverlässig und mechanisch stabil im oder am Gehäuse angeordnet werden, ohne dass zusätzliche Teile wie Schrauben, ein Lot oder Ähnliches benötigt werden.

Einer weiteren möglichen Weiterbildung der Erfindung oder einer der vorangehend genannten Weiterbildungen liegt die Erkenntnis zu Grunde, dass eine weitere große Ursache von Beeinträchtigungen von gattungsgemäßen Temperatursensoren in einer Diffusion von Partikeln, Molekülen oder Teilchen aus einem der beiden Leiter oder Thermodrähte über den Kontaktpunkt hinein in den jeweils anderen Leiter oder Thermodraht besteht. Solche Komponenten werden im Weiteren als Eigenkomponenten bezeichnet. Auch dieser Effekt läuft sehr langsam und schleichend ab und kann über Monate und Jahre zu einer Messstellenwanderung führen und sein Eintreten ist im laufenden Betrieb nicht feststellbar. In einer möglichen Weiterbildung der Erfindung kann diesem Effekt besonders effektiv entgegengetreten werden und somit die Schutzfunktion des Messstellenkörperaufbaus besonders effektiv umgesetzt werden, indem das Thermoelement durch die beiden Leiter nur mittelbar im oder am Messstellenkörperaufbau gebildet wird. Dabei kommt der elektrische Kontakt zwischen den beiden Leitern erst durch einen Abschnitt des Barriere-Materials zustande und das Barriere-Material ist derart gewählt, dass dieses bei gleicher Temperatur einen niedrigeren Diffusionskoeffizienten für mindestens eine im Material des ersten Leiters oder des zweiten Leiters vorhandene Eigenkomponente aufweist, als die Materialien der beiden Leiter selbst. Dadurch können mit dieser Weiterbildung entsprechende Vorteile erzielt werden, wie sie auch schon zur zuletzt beschriebenen Weiterbildung benannt wurden.

Die Schutzwirkung des Messstellenkörperaufbaus in Bezug auf diese zuletzt benannte Diffusion einer Eigenkomponente von einem Leiter zum anderen Leiter kann besonders effektiv umgesetzt werden, wenn das Barriere-Material einen besonders geringen Diffusionskoeffizienten für eine oder mehrere der Eigenkomponenten aufweist, welche nur im Material von einem der beiden Leiter vorkommt oder in einem der beiden Leiter mit deutlich höherer Konzentration vorliegt, als im Material des anderen Leiters. Diese Komponente ist beispielsweise:
- Chrom, wenn die beiden Leiter ein Thermoelement vom Typ-K oder Typ-N bilden, oder
- Nickel, wenn die beiden Leiter ein Thermoelement vom Typ-T bilden, oder
- Eisen, Kuper oder Nickel, wenn die beiden Leiter ein Thermoelement vom Typ-J bilden, oder
- Rhodium, wenn die beiden Leiter ein Thermoelement vom Typ-R oder Typ-S oder Typ-B bilden, oder
- Rhenium, wenn die beiden Leiter ein Thermoelement vom Typ-C oder Typ-A bilden.

In einer weiteren möglichen Weiterbildung der Erfindung oder einer der vorangehend genannten Weiterbildungen ist das Barriere-Material des Messstellenkörperaufbaus derart gewählt, dass dieses bei gleicher Temperatur eine höhere Wärmeleitfähigkeit und/oder einen geringeren elektrischen Widerstand und/oder eine höhere chemische Reaktionsträgheit und/oder eine geringere katalytische Kraft als die Materialien des ersten Leiters und/oder des zweiten Leiters und/oder des Gehäuses aufweist. Dadurch kann der Temperatursensor auf vielfältige Weise weiter verbessert werden. So kann beispielsweise eine hohe Wärmeleitfähigkeit dazu führen, dass der Temperatursensor eine verkürzte, schnelle Ansprechzeit aufweist. Ein geringer elektrischer Widerstand trägt zu einem genaueren, stärkeren Messsignal bei. Mit einer hohen chemischen Reaktionsträgheit und/oder geringen katalytischen Kraft kann der Messstellenkörperaufbau mit dem Barriere-Material - abgesehen von der möglichen, bereits genannten schützenden oder verzögernden Wirkung in Bezug auf Diffusionseffekte - das Thermoelement auch vor weiteren Umgebungseinflüssen effektiv schützen, zum Beispiel vor einer Beschädigung durch chemische Reaktionen.

Die in den vorangegangenen Abschnitten genannten positiven Schutzwirkungen können in Teilen oder auch insgesamt besonders effektiv erzielt werden, wenn das Barriere-Material gemäß einer weiteren möglichen Weiterbildung aus einem der folgenden Stoffe oder Materialien gewählt ist:
- Gold oder eine Goldlegierung, oder
- Platin oder eine Platinlegierung, oder
- Tantal oder eine Tantallegierung, oder
- Wolfram oder eine Wolframlegierung.

In einer weiteren möglichen Weiterbildung der Erfindung oder einer der vorangehend genannten Weiterbildungen ist mindestens einer der beiden Leiter durch einen Kraftschluss oder einen Stoffschluss im oder am Barriere-Material des Messstellenkörperaufbaus angeordnet. Durch eine kraft- oder stoffschlüssige Verbindung kann eine mechanisch stabile Anbindung der Leiter an das Barriere-Material erzielt werden; ebenso kann eine zuverlässige elektrische Verbindung zwischen dem Leiter oder den Leitern und dem Barriere-Material hergestellt werden, was insbesondere in Verbindung mit der in den vorangehenden Abschnitten beschriebenen mittelbaren Ausbildung eines Thermoelements im oder am Messstellenkörperaufbau vorteilhaft ist.

In einer weiteren möglichen Weiterbildung der Erfindung oder einer der vorangehend genannten Weiterbildungen umfasst der Temperatursensor zusätzlich einen dritten Leiter aus einem dritten Material mit einem Endabschnitt und einen vierten Leiter aus einem vierten Material, welches sich vom dritten Material unterscheidet, mit einem Endabschnitt. Dabei bilden der dritte Leiter und der vierte Leiter in dem oder an dem Messstellenkörperaufbau unmittelbar oder mittelbar ein weiteres Thermoelement, welches im Folgenden auch als Vergleichs-Thermoelement bezeichnet wird.

Die in den vorangehenden Abschnitten im Zusammenhang mit dem ersten und zweiten Leiter getroffenen Feststellungen und Ausführungen über die Endabschnitte der Leiter, die mittelbare oder unmittelbare Bildung eines Thermoelements im oder am Messstellenkörperaufbau, die Aufnahme von Endabschnitten in einem Messstellenkörper sowie die Herstellung eines direkten Kontakts zwischen einem Endabschnitt und einem Messstellenkörper sind entsprechend auch auf den dritten und vierten Leiter anwendbar.

Durch die Bildung des Vergleichs-Thermoelements wird es in vorteilhafter Weise möglich, im laufenden Betrieb festzustellen, ob eine Schutzwirkung durch das Barriere-Material des Messstellenkörperaufbaus noch gegeben ist oder ob der Temperatursensor bereits durch Umgebungseinflüsse beeinträchtigt ist, weil der Messstellenkörperaufbau zum Beispiel beschädigt ist. Diese Feststellung kann durch einen fortlaufenden Vergleich der Messwerte von den beiden Thermoelementen getroffen werden. Umgebungseinflüsse sowie durch diese hervorgerufene Effekte, insbesondere die in den vorangehenden Abschnitten beschriebenen Diffusionseffekte durch Fremdkomponenten oder Eigenkomponenten, werden sich nicht absolut identisch auf beide Thermoelemente auswirken, da das Thermoelement und das Vergleichs-Thermoelement fertigungsbedingt grundsätzlich nicht absolut identisch sein werden. Somit zeigen sich zunehmende Beeinträchtigungen durch Umgebungseinflüsse in einer zunehmenden Abweichung der Messwerte voneinander oder einer Veränderung eines Verhältnisses der Messwerte zueinander. Somit kann der Betreiber der Prozessanlage im laufenden Betrieb tatsächlich feststellen, dass eine Schutzwirkung durch den Messstellenkörperaufbau nachgelassen hat und/oder eine Beeinträchtigung des Temperatursensors eingesetzt hat und kann den Temperatursensor somit rechtzeitig austauschen.

In einer möglichen Weiterentwicklung dieser Weiterbildung weisen der dritte Leiter und/oder der vierte Leiter einen Durchmesser auf, welcher größer als ein Durchmesser des ersten Leiters und/oder des zweiten Leiters ist. Zusätzlich oder alternativ hierzu unterscheidet sich zumindest das dritte Material vom ersten Material und vom zweiten Material. Auch können alle vier Materialien der vier Leiter unterschiedlich sein. Der dritte Leiter und der vierte Leiter bilden dann also ein Thermoelement von einem Typ, der sich von einem Typ des Thermoelements unterscheidet, welches durch den ersten und zweiten Leiter gebildet wird. Durch die vorgeschlagenen geometrischen oder auch materiellen Unterschiede kann in vorteilhafter Weise erreicht werden, dass sich das Thermoelement, welches durch den ersten und zweiten Leiter gebildet wird, und das Vergleichs-Thermoelement noch deutlicher unterscheiden und somit auch noch stärker verschieden auf mögliche Umgebungseinflüsse, sowie durch diese hervorgerufene Effekte, reagieren. Somit können die im vorangegangenen Abschnitt genannten Überwachungs- und Erkennungsfunktionen noch präziser und zuverlässiger ausgeführt werden.

Die im Vorangehenden beschriebenen verschiedenen Weiterbildungen und Weiterentwicklungen einzelner Aspekte der Erfindung sind untereinander kombinierbar, insofern sie sich nicht widersprechen. Die der Erfindung zugrunde liegende Lehre ist dabei nicht auf die hier gewählte konkrete Reihenfolge oder Abfolge der Merkmale beschränkt.

### KURZBESCHREIBUNG DER FIGUREN

Mögliche Ausführungsbeispiele der Erfindung und ihrer Weiterbildungen werden im Folgenden anhand von Figuren näher erläutert. Dabei zeigen
- Figur 1: schematisch eine Schnittdarstellung eines Temperatursensors nach dem Stand der Technik,
- Figur 2: schematisch eine Schnittdarstellung eines Temperatursensors mit einem Messstellenkörperaufbau,
- Figur 3: schematisch eine Schnittdarstellung eines Temperatursensors mit einem Messstellenkörperaufbau,
- Figur 4: schematisch eine Schnittdarstellung eines Temperatursensors mit einem Messstellenkörperaufbau und einem dritten und vierten Leiter,
- Figur 5: schematisch eine Schnittdarstellung eines Messstellenkörpers,
- Figur 6: schematisch eine Draufsicht des Messstellenkörpers gemäß Figur 5,
- Figur 7: schematisch eine Schnittdarstellung eines Messstellenkörpers mit zwei Leitern,
- Figur 8: schematisch eine Schnittdarstellung eines Messstellenkörpers mit zwei Leitern,
- Figur 9: schematisch eine Schnittdarstellung eines Temperatursensors mit einem Messstellenkörperaufbau und
- Figur 10: schematisch eine Schnittdarstellung eines Messstellenkörpers mit zwei Leitern.

Einander entsprechende Teile sind in allen Figuren mit den gleichen Bezugszeichen versehen.

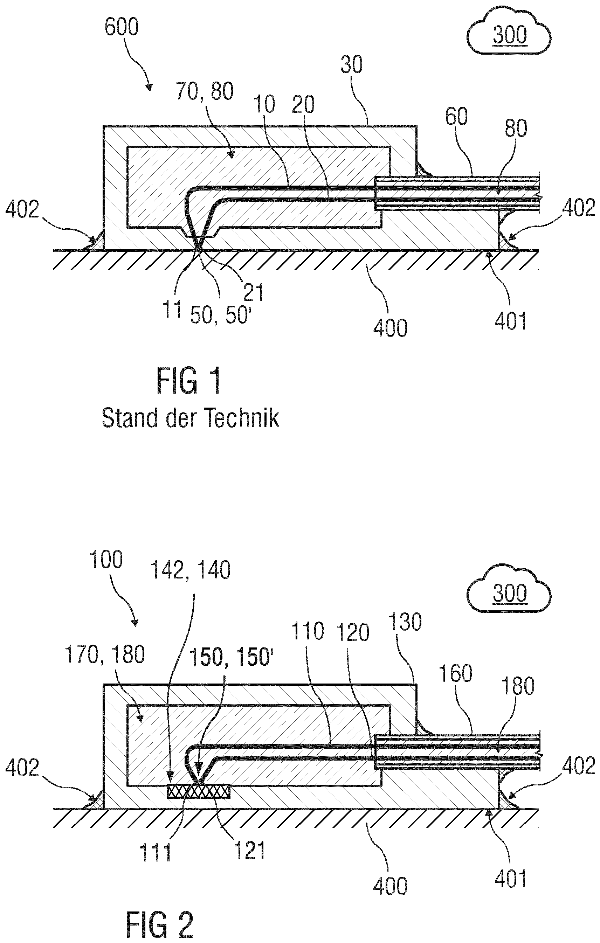

Figur 1 zeigt eine Schnittdarstellung eines Temperatursensors 600, wie er aus dem Stand der Technik bekannt ist. Ein erster Leiter 10 mit einem Endabschnitt 11 und ein zweiter Leiter 20 mit einem Endabschnitt 21 sind mithilfe einer Mantelleitung 60 an ein Gehäuse 30 herangeführt. Die Mantelleitung 60 ist in eine Öffnung des Gehäuses 30 eingeführt und dichtend mit dem Gehäuse 30 verschweißt. Das heißt, die Öffnung des Gehäuses 30 wird durch die darin eingeschweißte Mantelleitung 60 dichtend verschlossen. Sowohl die Mantelleitung 60, als auch ein freies Innenvolumen 70 des Gehäuses 30 sind mit einem mineralischen oder keramischen Isolationsmaterial 80 ausgefüllt, zum Beispiel einem Pulver. Die Leiter 10, 20 bestehen aus verschiedenen Materialien, sind im Gehäuse 30 an einen Kontaktpunkt 50` herangeführt und bilden dort durch eine Verbindung ihrer Endabschnitte 11, 21 ein Thermoelement 50 aus. In diesem Beispiel sind der erste Leiter 10 und der zweite Leiter 20 mit einem dünnen Abschnitt einer Gehäusewand verschweißt. Somit steht das Thermoelement 50 fast unmittelbar in Kontakt mit einer Oberfläche 401 einer Prozessstruktur 400, deren Temperatur gemessen werden soll. Das Gehäuse 30 ist mit der Oberfläche 401 durch Schweißnähte 402 verbunden.

Ein solcher Temperatursensor 600 weist zwar in der Regel eine schnelle Ansprechzeit und hohe Messgenauigkeit auf, allerdings ist das Thermoelement 50 durch das Gehäuse 30 primär nur vor Beeinträchtigungen durch Umgebungseinflüsse aus einer das Gehäuse 30 oder die Prozessstruktur 400 umgebenden Prozessatmosphäre 300 geschützt. Und selbst dieser Schutz kann - abhängig von der konkreten Anwendung - auch nur mittelfristig gegeben sein.

In den Figuren 2, 3 und 4 ist jeweils eine Schnittdarstellung jeweils eines möglichen Ausführungsbeispiels eines Temperatursensors 100 mit einem Messstellenkörperaufbau 140 dargestellt. Ein erster Leiter 110 mit einem Endabschnitt 111 und ein zweiter Leiter 120 mit einem Endabschnitt 121 sind mit einer Mantelleitung 160 an ein Gehäuse 130 herangeführt. Der zweite Leiter 120 besteht aus einem anderen Material als der erste Leiter 110. Beispielsweise sind die Mantelleitung 160 und ein freies Innenvolumen 170 des Gehäuses 130 mit einem mineralischen oder keramischen Isolationsmaterial 180 aufgefüllt, zum Beispiel einem Pulver, welches hier durch eine Schraffur der Flächen angedeutet ist. Das Gehäuse 130 ist auf einer Oberfläche 401 einer Prozessstruktur 400 angeordnet und mit dieser durch Schweißnähte 402 verbunden. Weiterhin ist das Gehäuse 130 von einer Prozessatmosphäre 300 umgeben, welche durch eine Wolkenform schematisch angedeutet ist. Das Gehäuse 130 sowie die Mantelleitung 160 schützen die beiden Leiter 110, 120, sowie das durch deren Endabschnitte 111, 121 gebildete Thermoelement 150 in gewissem Maße vor Beeinträchtigungen durch die Prozessatmosphäre 300. Das Thermoelement 150 ist zur Messung der Temperatur der Oberfläche 401 der Prozessstruktur 400 entsprechend innerhalb des Gehäuses 130 nahe an der Oberfläche 401 angeordnet.

In Figur 2 umfasst der Messstellenkörperaufbau 140 einen einzelnen, einteiligen Messstellenkörper 142 in einer Scheiben- oder Plattenform. Die Endabschnitte 111, 121 der beiden Leiter 110, 120 sind an einen Kontaktpunkt 150' an einer Oberfläche des Messstellenkörpers 142 herangeführt und dort unmittelbar miteinander verbunden. Durch diese Verbindung wird ein Thermoelement 150 ausgebildet.

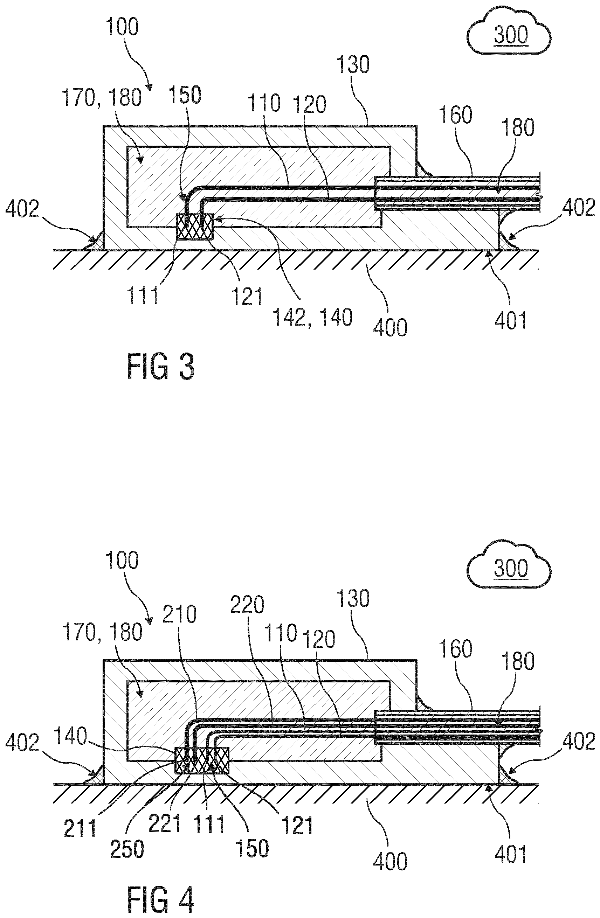

In Figur 3 umfasst der Messstellenkörperaufbau 140 ebenfalls einen einzelnen, einteiligen Messstellenkörper 142. Die Endbereiche 111, 121 der beiden Leiter 110, 120 sind jedoch nicht an einen gemeinsamen Kontaktpunkt 150' herangeführt, sondern erreichen den Messstellenkörper 142 an voneinander beabstandeten Stellen. Durch diese Verbindungen zwischen dem Endbereich 111 des ersten Leiters 110 und dem Messstellenkörper 142 sowie zwischen dem Endbereich 121 des zweiten Leiters 120 und dem Messstellenkörper 142 bilden die Endabschnitte 111, 121 der beiden Leiter 110, 120 mittelbar ein Thermoelement 150 aus.

In Figur 4 weist der Temperatursensor 100 zusätzlich einen dritten Leiter 210 und einen vierten Leiter 220 auf, welche ebenfalls durch die Mantelleitung 160 heran an und hinein in das Gehäuse 130 geführt sind. Der vierte Leiter 220 besteht aus einem anderen Material als der dritte Leiter 210. Der erste und zweite Leiter 110, 120 sind mit ihren Endabschnitten 111, 121 an den Messstellenkörperaufbau 140 mit dem Messstellenkörper 142 herangeführt und bilden dort mittelbar - über den Messstellenkörperaufbau 140 - ein Thermoelement 150. Der dritte und vierte Leiter 210, 220 sind ebenfalls mit ihren Endabschnitten 211, 221 an den Messstellenkörperaufbau 140 herangeführt und bilden dort ebenfalls mittelbar - über einen jeweiligen Kontakt mit dem Messstellenkörperaufbau 140 - ein Vergleichs-Thermoelement 250.

Durch den Messstellenkörperaufbau 140 oder durch den Messstellenkörper 142 sind die jeweils unmittelbar, respektive mittelbar gebildeten Thermoelemente 150 sowie auch das Vergleichs-Thermoelement 250 aus Figur 4 in vorteilhafter Weise vor Beeinträchtigungen durch Umgebungseinflüsse geschützt, denn der Messstellenkörperaufbau 140 umfasst ein Barriere-Material. Insbesondere kann der Messstellenkörper 142 in Figur 2 und Figur 3 aus dem Barriere-Material bestehen.

Das Barriere-Material weist in den Ausführungsformen in den Figuren 2 bis 4 insbesondere einen niedrigeren Diffusionskoeffizienten für mindestens eine in der Prozessatmosphäre 300 und/oder im Material des Gehäuses 130 und/oder im Material der Oberfläche 401 der Prozessstruktur 400 vorhandene Fremdkomponente auf, als die Materialien der jeweiligen Leiter 110, 120, 210, 220. Dadurch kann das Barriere-Material das Thermoelement 150 oder das Vergleichs-Thermoelement 250 wirksam vor einer Diffusion von solchen Fremdkomponenten in das Thermoelement 150 oder in das Vergleichs-Thermoelement 250 hinein schützen. Eine durch die Diffusion von Fremdkomponenten verursache Messstellenwanderung kann dadurch wirksam vermieden oder zumindest enorm verzögert werden.

Darüber hinaus weist das Barriere-Material in den Ausführungsformen in Figur 3 und Figur 4 insbesondere einen niedrigeren Diffusionskoeffizienten für mindestens eine im Material von mindestens einem der Leiter 110, 120, 210, 220 vorhandene Eigenkomponente auf, als die Materialien der Leiter 110, 120, 210, 220 selbst. Dadurch kann das Barriere-Material das mittelbar gebildete Thermoelement 150 oder das mittelbar gebildete Vergleichs-Thermoelement 250 in dieser Anordnung wirksam vor einer Diffusion von solchen Eigenkomponenten vom einen Leiter 110, 120, 210, 220 zum anderen schützen. Eine durch die Diffusion von Eigenkomponenten verursache Messstellenwanderung kann dadurch wirksam vermieden oder zumindest enorm verzögert werden.

In der in Figur 4 gezeigten Ausführungsform besteht wenigstens einer der beiden Leiter 210, 220 aus einem Material, welches sich von den Materialien des ersten Leiters 110 und des zweiten Leiters 120 unterscheidet. Somit unterscheidet sich das Vergleichs-Thermoelement 250 schon durch seine Materialkombination vom Thermoelement 150. Weiterhin weisen der dritte und vierte Leiter 210, 220 einen größere Drahtstärke auf als der erste und zweite Leiter 110, 120. Durch diese beiden Unterschiede kann erreicht werden, dass das Vergleichs-Thermoelement 250 auf Beeinträchtigungen durch Umgebungseinflüsse anders reagiert als das Thermoelement 150. Somit wird das Eintreten solcher Effekte messtechnisch erfassbar. Solche Beeinträchtigungen könnten insbesondere eintreten, wenn der Messstellenkörperaufbau 140 beschädigt wird.

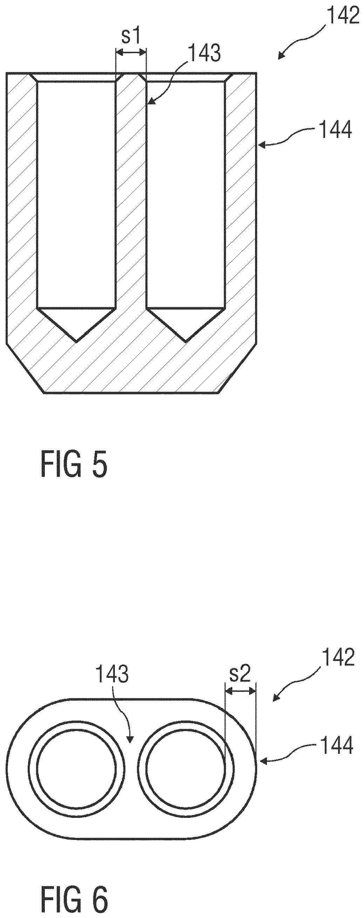

Die Figuren 5 und 6 zeigen eine mögliche exemplarische Ausgestaltung eines einteiligen Messstellenkörpers 142. In Figur 5 ist der Messstellenkörper 142 in einem Querschnitt zu sehen, in Figur 6 in einer Draufsicht auf eine Oberfläche, welche im eingebauten Zustand in einem Temperatursensor 100 einem Endabschnitt 111 eines ersten Leiters 110 und einem Endabschnitt 121 eines zweiten Leiters 120 zugewandt wird. Der Messstellenkörper 142 ist aus einem Barriere-Material gebildet. Der Messstellenkörper 142 weist zwei Ausnehmungen oder zwei Bohrungen auf, in welche die Endabschnitte 111, 121 eingeführt werden können. Zwischen diesen Ausnehmungen oder Bohrungen ist eine Trennwand 143 angeordnet, welche insbesondere eine Stärke s 1 von mindestens 0,1 mm aufweist. Die Ausnehmungen oder Bohrungen sind weiterhin von einer Außenwand 144 umgeben, welche ebenfalls insbesondere eine Stärke s2 von mindestens 0,1 mm aufweist. In dieser Ausführung ist der Messstellenkörper 142 besonders einfach und günstig herzustellen. Weiterhin wird nur eine geringe Menge an Barriere-Material benötigt, um die Endabschnitte 111, 121 wirksam zu schützen und mittelbar ein Thermoelement 150 auszubilden. Zudem kann auch eine Montage des Messstellenkörpers 142 in oder an ein Gehäuse 130 günstig und simpel erfolgen, beispielsweise durch eine Presspassung.

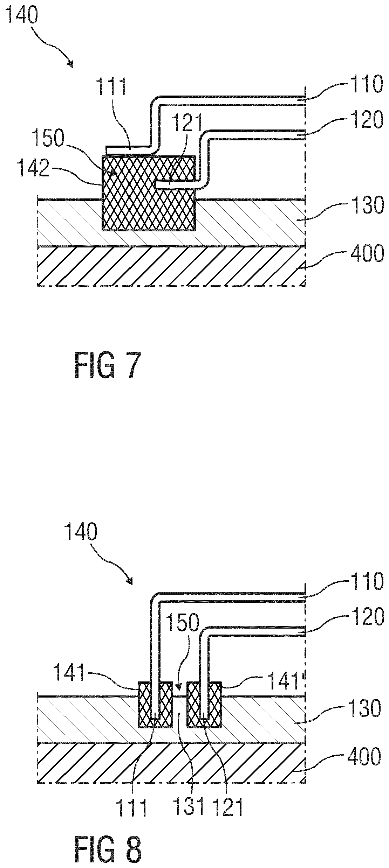

Die Figuren 7 und 8 zeigen in Schnittdarstellungen einen exemplarischen Messstellenkörperaufbau 140, welcher in einer Gehäusewand eines nur abschnittsweise dargestellten Gehäuses 130 angeordnet sind. Das Gehäuse 130 liegt auf einer Prozessstruktur 400 auf. Ein erster Leiter 110 mit einem Endabschnitt 111 und ein zweiter Leiter 120 mit einem Endabschnitt 121 sind an den Messstellenkörperaufbau 140 herangeführt und bilden an oder in diesem mittelbar ein Thermoelement 150.

In Figur 7 umfasst der Messstellenkörperaufbau 140 einen einzelnen Messstellenkörper 142, welcher aus einem Barriere-Material besteht. Der Endabschnitt 121 des zweiten Leiters 120 ist im Messstellenkörper 142 aufgenommen. Der Endabschnitt 111 des ersten Leiters 110 steht hingegen nur mit einer Oberfläche des Messstellenkörpers 142 in Kontakt. Die beiden Endabschnitte 111, 121 bilden über das Barriere-Material des Messstellenkörpers mittelbar ein Thermoelement 150.

In Figur 8 umfasst der Messstellenkörperaufbau 140 zwei getrennte Messstellenkörper 141, 141', welche jeweils aus einem Barriere-Material bestehen. Der Endabschnitt 111 des ersten Leiters 110 ist im Messstellenkörper 141 aufgenommen. Der Endabschnitt 121 des zweiten Leiters 120 ist im Messstellenkörper 141 ` aufgenommen. Die beiden Endabschnitte 111, 121 bilden über das Barriere-Material der Messstellenkörper 141, 141` sowie über einen Abschnitt 131 aus dem Material der Gehäusewand des Gehäuses 130 mittelbar ein Thermoelement 150.

Die in Figur 7 und 8 gezeigten Ausführungsformen eines Messstellenkörperaufbaus 140 sind in vorteilhafter Weise kostengünstig herzustellen und ermöglichen, dass die Endabschnitte 111, 121 der beiden Leiter 110, 120 wirksam vor Beeinträchtigungen durch Umgebungseinflüsse geschützt werden.

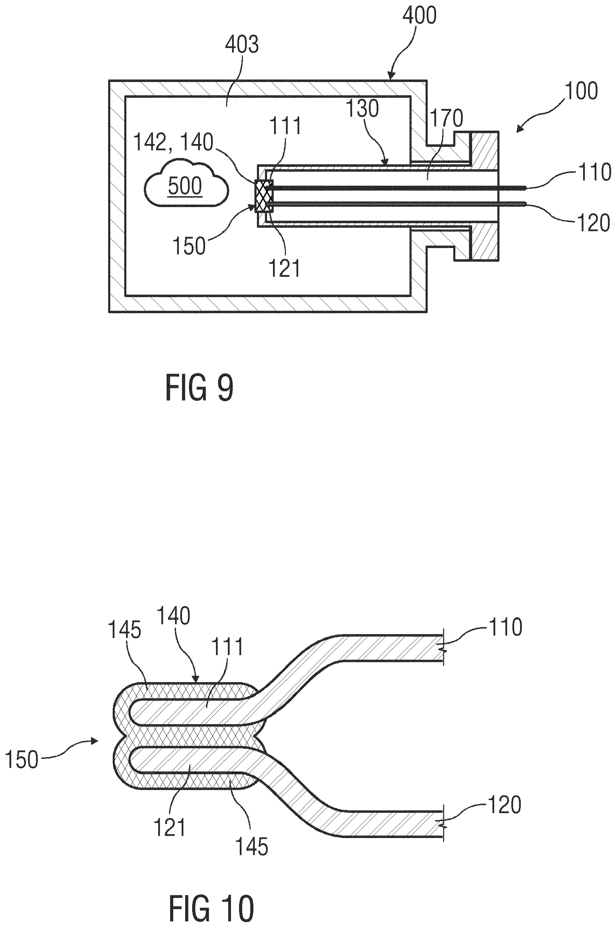

In Figur 9 ist eine weitere exemplarische Ausführungsform eines Temperatursensors 100 mit einem Messstellenkörperaufbau 140 oder mit einem Messstellenkörper 142 gezeigt. Der Messstellenkörper 142 besteht aus einem Barriere-Material. Ein erster Leiter 110 mit einem Endabschnitt 111 und ein zweiter Leiter 120 mit einem Endabschnitt 121 sind durch ein freies Innenvolumen 170 eines Gehäuses 130 an den Messstellenkörper 142 herangeführt. Das Gehäuse 130 ist in diesem Beispiel als ein Schutzrohr ausgeformt, welches abschnittsweise in eine Prozesskammer 403 einer Prozessstruktur 400 eingeführt ist. Innerhalb dieser Prozessstruktur 400 befindet sich ein Prozessfluid 500, welches durch eine Wolkenform schematisch angedeutet ist, oder das Prozessfluid 500 durchströmt die Prozessstruktur 400, falls diese beispielsweise als Rohrleitung ausgebildet ist. Der zweite Leiter 120 besteht aus einem anderen Material als der erste Leiter 110. Die Endabschnitte 111, 121 bilden durch einen Kontakt zum Messstellenkörper 142 mittelbar ein Thermoelement 150 aus. Der Messstellenkörper 142 ist derart am Gehäuse 130 angeordnet, dass er eine Gehäusewand abschnittsweise durchstößt und in direkten Kontakt mit dem Prozessfluid 500 kommt. Dadurch kann eine besonders hohe Messgenauigkeit und eine besonders kurze Ansprechzeit des Temperatursensors 100 bei der Messung der Temperatur des Prozessfluids 500 erzielt werden. Gleichzeitig schützt das Barriere-Material des Messstellenkörpers 142 wirkungsvoll die Endabschnitte 111, 121 der Leiter 110, 120 vor Beeinträchtigungen durch Umgebungseinflüsse, insbesondere auch vor Diffusionseffekten.

Figur 10 zeigt eine exemplarische Ausführungsform eines Messstellenkörperaufbaus 140 mit einem ersten Leiter 110 und einem zweiten Leiter 120. Der Messstellenkörperaufbau 140 ist als eine Beschichtung 145 an einem Endbereich 111 des ersten Leiters 110 und an einem Endbereich 121 des zweiten Leiters 120 ausgebildet. Die beiden Endbereiche 111, 121 sind derart aneinander geführt, dass sich deren Beschichtungen 145 berühren, insbesondere miteinander stoffschlüssig verbunden sind. Das Auftragen der Beschichtung 145 kann beispielsweise durch eine Lackierung, ein Einwickeln in eine Folie oder ein Eintauchen in eine Schmelze erfolgen. Die Beschichtung 145 besteht aus einem Barriere-Material und ist derart dick aufgetragen, dass sie zumindest mögliche Unebenheiten und Rauigkeiten in der Oberfläche der beiden Endbereiche 111, 121 überdeckt. Dennoch kann in dieser Weise die Schutzwirkung vor Beeinträchtigungen durch Umgebungseinflüsse wirksam und unter möglichst geringem Einsatz des Barriere-Materials erzielt werden.

### BEZUGSZEICHENLISTE

- 10: erster Leiter
- 11: Endabschnitt
- 20: zweiter Leiter
- 21: Endabschnitt
- 30: Gehäuse
- 50: Thermoelement
- 50`: Kontaktpunkt
- 60: Mantelleitung
- 70: Innenvolumen
- 80: Isolationsmaterial
- 100: Temperatursensor
- 110: erster Leiter
- 111: Endabschnitt
- 120: zweiter Leiter
- 121: Endabschnitt
- 130: Gehäuse
- 131: Abschnitt
- 140: Messstellenkörperaufbau
- 141: Messstellenkörper
- 141': Messstellenkörper
- 142: Messstellenkörper
- 143: Trennwand
- 144: Außenwand
- 145: Beschichtung
- 150: Thermoelement
- 150`: Kontaktpunkt
- 160: Mantelleitung
- 170: Innenvolumen
- 180: Isolationsmaterial
- 210: dritter Leiter
- 211: Endabschnitt
- 220: vierter Leiter
- 221: Endabschnitt
- 250: Vergleichs-Thermoelement
- 300: Prozessatmosphäre
- 400: Prozessstruktur
- 401: Oberfläche
- 402: Schweißnaht
- 403: Prozesskammer
- 500: Prozessfluid
- 600: Temperatursensor

- s1, s2: Stärke

## Patentansprüche

1. Temperatursensor (100) umfassend
- einen ersten Leiter (110) aus einem ersten Material mit einem Endabschnitt (111),
- einen zweiten Leiter (120) aus einem zweiten Material, welches sich vom ersten Material unterscheidet, mit einem Endabschnitt (121),
- ein Gehäuse (130) zur Aufnahme der Endabschnitte (111, 121) der beiden Leiter (110, 120) und zur Positionierung in einer Prozessatmosphäre (300) oder in einem Prozessfluid (500) und/oder an einer Oberfläche (401) einer Prozessstruktur (400),
- einen Messstellenkörperaufbau (140), welcher innerhalb des Gehäuses (130) oder an dem Gehäuse (130) angeordnet ist, wobei
- der erste Leiter (110) und der zweite Leiter (120) in dem oder an dem Messstellenkörperaufbau (140) unmittelbar oder mittelbar ein Thermoelement (150) bilden und
- der Messstellenkörperaufbau (140) ein Barriere-Material umfasst,
**dadurch gekennzeichnet, dass**
das Barriere-Material bei gleicher Temperatur einen niedrigeren Diffusionskoeffizienten für mindestens eine in der Prozessatmosphäre (300) und/oder im Prozessfluid (500) und/oder im Material des Gehäuses (130) und/oder im Material der Oberfläche (401) der Prozessstruktur (400) vorhandene Fremdkomponente aufweist als die Materialien der beiden Leiter (110, 120).

2. Temperatursensor (100) nach Anspruch 1, **dadurch gekennzeichnet, dass** die Endbereiche (111, 121) der beiden Leiter (110, 120) unmittelbar elektrisch miteinander an einem Kontaktpunkt (150`) verbunden sind, wobei
- der Kontaktpunkt (150') innerhalb des Barriere-Materials des Messstellenkörperaufbaus (140) liegt oder
- der Kontaktpunkt (150') am Barriere-Material des Messstellenkörperaufbaus (140) anliegt.

3. Temperatursensor (100) nach Anspruch 1, **dadurch gekennzeichnet, dass** die Endbereiche (111, 121) der beiden Leiter (110, 120) über einen oder mehrere Materialabschnitte des Messstellenkörperaufbaus (140), insbesondere über einen Abschnitt des Barriere-Materials des Messstellenkörperaufbaus (140), elektrisch miteinander verbunden sind.

4. Temperatursensor (100) nach Anspruch 3, **dadurch gekennzeichnet, dass** der Messstellenkörperaufbau (140) einen einzelnen Messstellenkörper (142) aufweist, wobei
- dieser Messstellenkörper (142) die Endbereiche (111, 121) der beiden Leiter (110, 120) aufnimmt oder zumindest mit diesen in unmittelbarem Kontakt steht, und wobei
- der Messstellenkörper (142) insbesondere aus dem Barriere-Material besteht.

5. Temperatursensor (100) nach Anspruch 1, **dadurch gekennzeichnet, dass** die Endbereiche (111, 121) der beiden Leiter (110, 120) über mindestens einen Abschnitt des Messstellenkörperaufbaus (140), insbesondere über einen Abschnitt des Barriere-Materials des Messstellenkörperaufbaus (140), und mindestens einen Abschnitt (131) des Gehäuses (130) elektrisch miteinander verbunden sind.

6. Temperatursensor (100) nach Anspruch 5, **dadurch gekennzeichnet, dass** der Messstellenkörperaufbau (140) zwei getrennte Messstellenkörper (141, 141') aufweist, wobei
- jeder dieser Messstellenkörper (141, 141 ') jeweils einen Endbereich (111, 121) von einem der beiden Leiter (110, 120) aufnimmt oder mit diesem in unmittelbarem Kontakt steht, und wobei
- die Messstellenkörper (141, 141') insbesondere aus dem Barriere-Material bestehen.

7. Temperatursensor (100) nach Anspruch 4, **gekennzeichnet durch**
- eine Trennwand (143) des Messstellenkörpers (142), welche zwischen den Endabschnitten (111, 121) der beiden Leiter (110, 120) angeordnet ist und eine Stärke (s1) von mindestens 0,1 mm aufweist, und/oder
- eine Außenwand (144) des Messstellenkörpers (142), welche den Endabschnitt (111) des ersten Leiters (110) und/oder den Endabschnitt (121) des zweiten Leiters (120) umgibt und eine Stärke (s2) von mindestens 0,1 mm aufweist.

8. Temperatursensor (100) nach einem der Ansprüche 4 bis 7, **dadurch gekennzeichnet, dass**
der zumindest eine Messstellenkörper (141, 141', 142)
- durch eine Beschichtung (145) oder eine Lackierung des Endbereichs (111, 121) von wenigstens einem der Leiter (110, 120) mit dem Barriere-Material, oder
- durch Einhüllung des Endbereichs (111, 121) von wenigstens einem der Leiter (110, 120) in eine Folie aus dem Barriere-Material
gebildet ist.

9. Temperatursensor (100) nach einem der Ansprüche 4 bis 8, **dadurch gekennzeichnet, dass**
der zumindest eine Messstellenkörper (141, 141', 142) durch Presspassung im oder am Gehäuse (130) angeordnet ist.

10. Temperatursensor (100) nach einem der vorangegangenen Ansprüche, **dadurch gekennzeichnet, dass**
die Fremdkomponente zumindest eine der Substanzen
- Kohlenstoff, oder
- Schwefel, oder
- Chrom, oder
- Nickel, oder
- Eisen, oder
- Kupfer, oder
- eine beliebige Komponente des ersten und/oder zweiten Materials ist.

11. Temperatursensor (100) nach einem der vorangegangenen Ansprüche,
**dadurch gekennzeichnet, dass**
das Barriere-Material bei gleicher Temperatur einen niedrigeren Diffusionskoeffizienten für mindestens eine im Material des ersten Leiters (110) oder im Material des zweiten Leiters (120) vorhandene Eigenkomponente aufweist als die Materialien der beiden Leiter (110, 120) selbst, und/oder
die Eigenkomponente aus dem Material des ersten Leiters (110) oder des zweiten Leiters (120) insbesondere
- Chrom ist, wenn die beiden Leiter (110, 120) ein Thermoelement vom Typ-K oder Typ-N bilden, oder
- Nickel ist, wenn die beiden Leiter (110, 120) ein Thermoelement vom Typ-T bilden, oder
- Eisen, Kupfer oder Nickel ist, wenn die beiden Leiter (110, 120) ein Thermoelement vom Typ-J bilden, oder
- Rhodium ist, wenn die beiden Leiter (110, 120) ein Thermoelement vom Typ-R oder Typ-S oder Typ-B bilden, oder
- Rhenium ist, wenn die beiden Leiter (110, 120) ein Thermoelement vom Typ-C oder Typ-A bilden, oder
- eine beliebige Komponente des ersten Materials oder des zweiten Materials ist, welche im jeweils anderen Leitermaterial nicht oder nur in deutlich geringerer Konzentration vorkommt.

12. Temperatursensor (100) nach einem der vorangegangenen Ansprüche, **dadurch gekennzeichnet, dass**
das Barriere-Material bei gleicher Temperatur
- eine höhere Wärmeleitfähigkeit und/oder
- einen geringeren elektrischen Widerstand und/oder
- eine höhere chemische Reaktionsträgheit und/oder
- eine geringere katalytische Kraft
als die Materialien des ersten Leiters (110) und/oder des zweiten Leiters (120) und/oder des Gehäuses (130) aufweist.

13. Temperatursensor (100) nach einem der vorangegangenen Ansprüche, **dadurch gekennzeichnet, dass**
das Barriere-Material
- Gold oder eine Goldlegierung, oder
- Platin oder eine Platinlegierung, oder
- Tantal oder eine Tantallegierung, oder
- Wolfram oder eine Wolframlegierung
umfasst oder ist.

14. Temperatursensor (100) nach einem der vorangegangenen Ansprüche,
**dadurch gekennzeichnet, dass**
die beiden Leiter (110, 120) mit einer Mantelleitung (160) oder einer mineralisolierten Leitung an das Gehäuse (130) herangeführt sind.

15. Temperatursensor (100) nach einem der vorangegangenen Ansprüche,
**dadurch gekennzeichnet, dass**
das Gehäuse (130) auf der Oberfläche (401) der Prozessstruktur (400) aufgeschweißt oder angefügt ist.

16. Temperatursensor (100) nach einem der vorangegangenen Ansprüche,
**dadurch gekennzeichnet, dass**
ein freies Innenvolumen (170) des Gehäuses (130) mit einem elektrischen Isolationsmaterial (180), insbesondere mit einem mineralischen oder keramischen Isolationsmaterial, aufgefüllt ist.

17. Temperatursensor (100) nach einem der vorangegangenen Ansprüche,
**dadurch gekennzeichnet, dass**
der Messstellenkörperaufbau (140) zumindest abschnittsweise in direktem Kontakt mit dem Prozessfluid (500) oder der Oberfläche (401) der Prozessstruktur (400) steht.

18. Temperatursensor (100) nach einem der vorangegangenen Ansprüche, **gekennzeichnet durch**
- einen dritten Leiter (210) aus einem dritten Material, mit einem Endabschnitt (211), und
- einen vierten Leiter (220) aus einem vierten Material, welches sich vom dritten Material unterscheidet, mit einem Endabschnitt (221), wobei
- der dritte Leiter (210) und der vierte Leiter (220) in dem oder an dem Messstellenkörperaufbau (140) unmittelbar oder mittelbar ein Vergleichs-Thermoelement (250) bilden.

19. Temperatursensor (100) nach Anspruch 18, **dadurch gekennzeichnet, dass**
- der dritte Leiter (210) und/oder der vierte Leiter (220) einen Durchmesser aufweisen, welcher größer als ein Durchmesser des ersten Leiters (110) und/oder des zweiten Leiters (120) ist, und/oder
- sich zumindest das dritte Material vom ersten und zweiten Material unterscheidet.

## Claims

1. Temperature sensor (100) comprising
- a first conductor (110) made of a first material and having an end section (111),
- a second conductor (120) made of a second material, which differs from the first material, and having an end section (121);
- a casing (130) for receiving the end sections (111, 121) of the two conductors (110, 120) and intended for positioning in a process atmosphere (300) or in a process fluid (500) and/or on a surface (401) of a process structure (400);
- a measuring junction structure (140), which is arranged within the casing (130) or on the casing (130), wherein
- the first conductor (110) and the second conductor (120) directly or indirectly form a thermocouple (150) in or on the measuring junction structure, (140) and
- the measuring junction structure (140) comprises a barrier material,
**characterized in that**
the barrier material has at the same temperature a lower diffusion coefficient for at least one foreign component present in the process atmosphere (300) and/or in the process fluid (500) and/or in the material of the casing (130) and/or in the material of the surface (401) of the process structure (400) than the materials of the two conductors (110, 120).

2. Temperature sensor (100) according to Claim 1, **characterized in that** the end regions (111, 121) of the two conductors (110, 120) are directly electrically connected to each other at a contact point (150'), wherein
- the contact point (150') lies within the barrier material of the measuring junction structure (140) or
- the contact point (150') lies against the barrier material of the measuring junction structure (140).

3. Temperature sensor (100) according to Claim 1, **characterized in that** the end regions (111, 121) of the two conductors (110, 120) are electrically connected to each other by way of one or more material sections of the measuring junction structure (140), in particular by way of a section of the barrier material of the measuring junction structure (140).

4. Temperature sensor (100) according to Claim 3, **characterized in that** the measuring junction structure (140) has a single measuring junction (142), wherein
- this measuring junction (142) receives the end regions (111, 121) of the two conductors (110, 120) or at least is in direct contact with them, and wherein
- the measuring junction (142) consists in particular of the barrier material.

5. Temperature sensor (100) according to Claim 1, **characterized in that** the end regions (111, 121) of the two conductors (110, 120) are electrically connected to each other by way of at least one section of the measuring junction structure (140), in particular by way of a section of the barrier material of the measuring junction structure (140), and at least one section (131) of the casing (130).

6. Temperature sensor according to Claim 5, **characterized in that** the measuring junction structure (140) has two separate measuring junctions (141, 141'), wherein
- each of these measuring junctions (141, 141') respectively receives an end region (111, 121) of one of the two conductors (110, 120) or is in direct contact with it, and wherein
- the measuring junctions (141, 141') consist in particular of the barrier material.

7. Temperature sensor (100) according to Claim 4, **characterized by**
- a partition wall (143) of the measuring junction (142), which is arranged between the end regions (111, 121) of the two conductors (110, 120) and has a thickness (s1) of at least 0.1 mm, and/or
- an outer wall (144) of the measuring junction (142), which surrounds the end region (111) of the first conductor (110) and/or the end region (121) of the second conductor (120) and has a thickness (s2) of at least 0.1 mm.

8. Temperature sensor (100) according to one of Claims 4 to 7, **characterized in that**
the at least one measuring junction (141, 141', 142) is formed
- by a coating (145) or a finish of the end region (111, 121) of at least one of the conductors (110, 120) with the barrier material, or
- by wrapping the end region (111, 121) of at least one of the conductors (110, 20) in a film of the barrier material.

9. Temperature sensor (100) according to one of Claims 4 to 8, **characterized in that**
the at least one measuring junction (141, 141', 142) is arranged in or on the casing (130) by press-fitting.

10. Temperature sensor (100) according to one of the preceding claims, **characterized in that**
the foreign component is at least one of the substances:
- carbon, or
- sulfur, or
- chromium, or
- nickel, or
- iron, or
- copper, or
- any component of the first and/or second material.

11. Temperature sensor (100) according to one of the preceding claims, **characterized in that**
the barrier material has at the same temperature a lower diffusion coefficient for at least one intrinsic component present in the material of the first conductor (110) or in the material of the second conductor (120) than the materials of the two conductors (110, 120) themselves and/or
the intrinsic component is made of the material of the first conductor (110) or the second conductor (120), in particular
- chromium when the two conductors (110, 120) form a K-type or N-type thermocouple, or
- nickel when the two conductors (110, 120) form a T-type thermocouple, or
- iron, copper, or nickel when the two conductors (110, 120) form a J-type thermocouple, or
- rhodium when the two conductors (110, 120) form an R-type or S-type or B-type thermocouple, or
- rhenium when the two conductors (110, 120) form a C-type or A-type thermocouple, or
- any component of the first material or the second material that does not occur in the respective other conductor material or only in a significantly lower concentration.

12. Temperature sensor (100) according to one of the preceding claims, **characterized in that**
the barrier material has at the same temperature
- a higher thermal conductivity and/or
- a lower electrical resistance and/or
- a higher chemical inertia and/or
- a lower catalytic force
than the materials of the first conductor (110) and/or the second conductor (120) and/or the casing (130).

13. Temperature sensor (100) according to one of the preceding claims, **characterized in that**
the barrier material comprises or is
- gold or a gold alloy, or
- platinum or a platinum alloy, or
- tantalum or a tantalum alloy, or
- tungsten or a tungsten alloy.

14. Temperature sensor (100) according to one of the preceding claims, **characterized in that**
the two conductors (110, 120) are led to the casing (130) by a sheathed cable (160) or a mineral-insulated cable.

15. Temperature sensor (100) according to one of the preceding claims, **characterized in that**
the casing (130) is welded or joined onto the surface (401) of the process structure (400).

16. Temperature sensor (100) according to one of the preceding claims, **characterized in that**
a free internal volume (170) of the casing (130) is filled with an electrical insulating material (180), in particular with a mineral or ceramic insulating material.

17. Temperature sensor (100) according to one of the preceding claims, **characterized in that**
the measuring junction structure (140) is at least partially in direct contact with the process fluid (500) or the surface (401) of the process structure (400).

18. Temperature sensor (100) according to one of the preceding claims, **characterized by**
- a third conductor (210) made of a third material and having an end section (211), and
- a fourth conductor (220) made of a fourth material, which differs from the third material, and having an end section (221), wherein
- the third conductor (210) and the fourth conductor (220) directly or indirectly form a reference thermocouple (250) in or on the measuring junction structure (140).

19. Temperature sensor (100) according to Claim 18, **characterized in that**
- the third conductor (210) and/or the fourth conductor (220) have a diameter which is greater than a diameter of the first conductor (110) and/or the second conductor (120), and/or
- at least the third material differs from the first and second material.

## Revendications

1. Capteur de température (100), comprenant
- un premier conducteur (110) d'un premier matériau, pourvu d'une partie d'extrémité (111),
- un deuxième conducteur (120) d'un deuxième matériau qui est différent du premier matériau, pourvu d'une partie d'extrémité (121),
- un boîtier (130) pour recevoir les parties d'extrémité (111, 121) des deux conducteurs (110, 120) et pour être positionné dans une atmosphère de processus (300) ou dans un fluide de processus (500) et/ou sur une surface (401) d'une structure de processus (400),
- une structure de corps de points de mesure (140) qui est disposée à l'intérieur du boîtier (130) ou sur le boîtier (130), dans lequel
- le premier conducteur (110) et le deuxième conducteur (120) constituent directement ou indirectement un thermocouple (150) dans ou sur la structure de corps de points de mesure (140), et
- la structure de corps de points de mesure (140) comprend un matériau barrière,
**caractérisé en ce que** le matériau barrière présente à température égale un coefficient de diffusion inférieur à celui des matériaux des deux conducteurs (110, 120), pour au moins un composant externe présent dans l'atmosphère de processus (300) et/ou dans le fluide de processus (500) et/ou dans le matériau du boîtier (130) et/ou dans le matériau de la surface (401) de la structure de processus (400).

2. Capteur de température (100) selon la revendication 1, **caractérisé en ce que** les zones d'extrémité (111, 121) des deux conducteurs (110, 120) sont reliées ensemble directement électriquement au niveau d'un point de contact (150'), dans lequel
- le point de contact (150') se trouve à l'intérieur du matériau barrière de la structure de corps de points de mesure (140), ou
- le point de contact (150') est adjacent au matériau barrière de la structure de corps de points de mesure (140).

3. Capteur de température (100) selon la revendication 1, **caractérisé en ce que** les zones d'extrémité (111, 121) des deux conducteurs (110, 120) sont reliées ensemble électriquement par l'intermédiaire d'une ou de plusieurs parties de matériau de la structure de corps de points de mesure (140), en particulier par l'intermédiaire d'une partie du matériau barrière de la structure de corps de points de mesure (140).

4. Capteur de température (100) selon la revendication 3, **caractérisé en ce que** la structure de corps de points de mesure (140) présente un seul corps de points de mesure (142), dans lequel
- ce corps de points de mesure (142) reçoit les zones d'extrémité (111, 121) des deux conducteurs (110, 120) ou est au moins en contact direct avec eux, et dans lequel
- le corps de points de mesure (142) est composé en particulier du matériau barrière.

5. Capteur de température (100) selon la revendication 1, **caractérisé en ce que** les zones d'extrémité (111, 121) des deux conducteurs (110, 120) sont reliées ensemble électriquement par l'intermédiaire d'au moins une partie de la structure de corps de points de mesure (140), en particulier par l'intermédiaire d'une partie du matériau de barrière de la structure de corps de points de mesure (140), et d'au moins une partie (131) du boîtier (130).

6. Capteur de température (100) selon la revendication 5, **caractérisé en ce que** la structure de corps de points de mesure (140) présente deux corps de points de mesure (141, 141') séparés, dans lequel
- chacun de ces corps de points de mesure (141, 141') reçoit respectivement une zone d'extrémité (111, 121) d'un des deux conducteurs (110, 120) ou est en contact direct avec celui-ci, et dans lequel
- les corps de points de mesure (141, 141') sont composés en particulier du matériau barrière.

7. Capteur de température (100) selon la revendication 4, **caractérisé par**
- une cloison (143) du corps de points de mesure (142) qui est disposée entre les parties d'extrémité (111, 121) des deux conducteurs (110, 120) et présente une épaisseur (s1) d'au moins 0,1 mm, et/ou
- une paroi extérieure (144) du corps de points de mesure (142) qui entoure la partie d'extrémité (111) du premier conducteur (110) et/ou la partie d'extrémité (121) du deuxième conducteur (120) et présente une épaisseur (s2) d'au moins 0,1 mm.

8. Capteur de température (100) selon l'une quelconque des revendications 4 à 7, **caractérisé en ce que** ledit au moins un corps de points de mesure (141, 141', 142) est formé
- par un revêtement (145) ou une couche de vernis de la zone d'extrémité (111, 121) d'au moins l'un des conducteurs (110, 120) pourvu du matériau barrière, ou
- par le gainage de la zone d'extrémité (111, 121) d'au moins l'un des conducteurs (110, 120) dans un film en matériau barrière.

9. Capteur de température (100) selon l'une quelconque des revendications 4 à 8, **caractérisé en ce que** ledit au moins un corps de points de mesure (141, 141', 142) est disposé par ajustement serré dans ou sur le boîtier (130).

10. Capteur de température (100) selon l'une quelconque des revendications précédentes, **caractérisé en ce que** le composant externe est au moins l'une des substances suivantes
- carbone, ou
- soufre, ou
- chrome, ou
- nickel, ou
- fer, ou
- cuivre, ou
- un composant quelconque du premier et/ou du deuxième matériau.

11. Capteur de température (100) selon l'une quelconque des revendications précédentes, **caractérisé en ce que** le matériau barrière présente à température égale pour au moins un composant propre présent dans le matériau du premier conducteur (110) ou dans le matériau du deuxième conducteur (120) un coefficient de diffusion inférieur à celui des matériaux des deux conducteurs (110, 120) eux-mêmes, et/ou
le composant propre composé du matériau du premier conducteur (110) ou du deuxième conducteur (120) est en particulier
- du chrome lorsque les deux conducteurs (110, 120) constituent un thermocouple de type K ou de type N, ou
- du nickel lorsque les deux conducteurs (110, 120) constituent un thermocouple de type T, ou
- du fer, du cuivre ou du nickel lorsque les deux conducteurs (110, 120) constituent un thermocouple de type J, ou
- du rhodium lorsque les deux conducteurs (110, 120) constituent un thermocouple de type R ou de type S ou de type B, ou
- du rhénium lorsque les deux conducteurs (110, 120) constituent un thermocouple de type C ou de type A, ou
- un composant quelconque du premier matériau ou du deuxième matériau qui n'est pas présent ou seulement en concentration nettement inférieure dans l'autre matériau de conducteur respectif.

12. Capteur de température (100) selon l'une quelconque des revendications précédentes, **caractérisé en ce que** le matériau barrière à température égale présente
- une conductibilité thermique supérieure, et/ou
- une résistance électrique inférieure, et/ou
- un manque de réaction chimique supérieur, et/ou
- une force catalytique inférieure
à ceux des matériaux du premier conducteur (110) et/ou du deuxième conducteur (120) et/ou du boîtier (130).

13. Capteur de température (100) selon l'une quelconque des revendications précédentes, **caractérisé en ce que** le matériau barrière comprend ou est
- de l'or ou un alliage d'or, ou
- du platine ou un alliage de platine, ou
- du tantale ou un alliage de tantale, ou
- du tungstène ou un alliage de tungstène.

14. Capteur de température (100) selon l'une quelconque des revendications précédentes, **caractérisé en ce que** les deux conducteurs (110, 120) sont amenés au boîtier (130) par un câble sous gaine (160) ou un câble à isolation minérale.

15. Capteur de température (100) selon l'une quelconque des revendications précédentes, **caractérisé en ce que** le boîtier (130) est soudé ou rapporté à la surface (401) de la structure de processus (400).

16. Capteur de température (100) selon l'une quelconque des revendications précédentes, **caractérisé en ce qu'**un volume intérieur libre (170) du boîtier (130) est rempli d'un matériau d'isolation électrique (180), en particulier d'un matériau d'isolation minéral ou céramique.

17. Capteur de température (100) selon l'une quelconque des revendications précédentes, **caractérisé en ce que** la structure de corps de points de mesure (140) est au moins par endroits en contact direct avec le fluide de processus (500) ou la surface (401) de la structure de processus (400).

18. Capteur de température (100) selon l'une quelconque des revendications précédentes, **caractérisé par**
- un troisième conducteur (210) d'un troisième matériau, pourvu d'une partie d'extrémité (211), et
- un quatrième conducteur (220) d'un quatrième matériau qui est différent du troisième matériau, pourvu d'une partie d'extrémité (221), dans lequel
- le troisième conducteur (210) et le quatrième conducteur (220) constituent dans ou sur la structure de corps de points de mesure (140) directement ou indirectement un thermocouple de comparaison (250).

19. Capteur de température (100) selon la revendication 18, **caractérisé en ce que**
- le troisième conducteur (210) et/ou le quatrième conducteur (220) présentent un diamètre qui est supérieur à un diamètre du premier conducteur (110) et/ou du deuxième conducteur (120), et/ou
- au moins le troisième matériau est différent du premier et du deuxième matériau.
